# DEMANDE DE BREVET EUROPEEN

(11) **EP 0 699 747 A1**
(43) Date de publication de la demande: **06.03.1996**
(21) Numéro de dépôt: 95401911.3
(22) Date de dépôt: 18.08.1995
(51) Int. Cl.: C11D 7/50, C11D 7/24, C23G 5/024, C11D 7/26

(54) **Composition de nettoyage**

(30) Priorité: 25.08.1994 FR 9410289
(71) Demandeur: ELF ATOCHEM S.A., F-92800 Puteaux (FR)
(72) Inventeur: Martin, Jean-Jacques, F-92270 Bois-Colombes (FR); Michaud, Pascal, F-95210 Saint-Gratien (FR)

(57) **Abrégé**

L'invention concerne une composition de nettoyage de surfaces en milieu non aqueux, comprenant un mélange d'alcanes et au moins un alcool de faible masse molaire, caractérisée en ce qu'elle comprend une quantité suffisante d'alcool de faible masse molaire pour obtenir un temps de séchage à 55°C au plus égal 80 secondes.

## Description

La présente invention concerne une composition de nettoyage de surfaces solides à base d'alcools de faible masse molaire et d'un mélange d'alcanes.

Cette composition est utilisable notamment pour le dégraissage des pièces mécaniques ayant été souillées par des huiles, des graisses utilisées couramment aux cours des opérations d'usinage des métaux et / ou de leur protection temporaire.

Cette composition est également utilisable pour le défluxage des circuits imprimés. Cette opération de défluxage consiste à éliminer le flux de soudure.

Jusqu'a présent on utilisait pour ces diverses opérations des solvants hydrocarbonés et principalement des solvants chlorés tels que notamment le 1,1,1-trichloroéthane connu dans le métier sous la désignation T 111, ainsi que des chlorofluoroalcanes tels que le 1,1,2-trichloro-1,2,2-trifluoroéthane connu dans le métier sous la désignation F 1113.

Cependant, ces composés chlorés et fluorochlorés sont suspectés être responsables de la diminution de la couche d'ozone stratosphérique qui assure une protection contre certaines radiations.

Suite au Protocole de Montréal qui résulte de récentes discussions internationales sur l'environnement ces composés chlorés ou fluorochlorés devront à brève échéance être remplacés par des substitus ayant peu ou pas d'effet destructeur vis à vis de la couche d'ozone stratosphérique.

La demande de brevet européenne EP 529869 propose pour remplacer ces composés, des compositions utilisables en milieu semi-aqueux comprenant des alcools et des alcanes. Plus précisément cette demande propose une composition comprenant de préférence 20% de 2-éthyl-1-hexanol et 80% d'un mélange de paraffines ayant de 10 à 13 atomes de carbone.

Cependant, ce document ne mentionne ni ne suggère une quelconque amélioration du temps de séchage. Par ailleurs, il est nécessaire de réajuster le pourcentage des divers constituants de la composition si l'on désire la recycler.

On a maintenant trouvé une composition de nettoyage de surfaces en milieu non aqueux et de défluxage des circuits imprimés, contenant au moins un alcool de faible masse molaire et au moins un mélange d'alcanes caractérisée en ce qu'elle comprend une quantité suffisante d'alcool de faible masse molaire pour obtenir un temps de séchage à 55°C au plus égal à 80 secondes, et de préférence, au plus égal à 70 secondes.

La composition selon la présente invention comprend des proportions pondérales d'alcool de faible masse molaire allant de 15% à 20% et de préférence, allant de 16% à 18%.

A titre d'exemple d'alcool de faible masse molaire utilisable selon la présente invention, on peut citer l'heptanol, l'hexanol, l'octanol, le 2-éthyl-1 hexanol et le mélange d'au moins deux des alcools précités.

Parmi les alcools de faible masse molaire l'invention concerne tout particulièrement le 2-éthyl-1-hexanol.

A titre d'exemple de mélange d'alcanes utilisable selon la présente invention on peut citer les coupes pétrolières ayant un nombre de carbone allant de 9 à 12.

Parmi ces coupes pétrolières l'invention concerne tout particulièrement celles qui ont un intervalle de distillation allant de 170°C à 210°C et, de préférence, allant de 175°C à 200°C.

Dans la composition selon la présente invention, les proportions pondérales de coupe pétrolière s'échelonnent de 85% à 80% et, de préférence, de 84% à 82%.

Parmi ces coupes pétrolières on préfère utiliser celles qui ne contiennent quasiment pas de carbures aromatiques et / ou naphténiques.

La composition selon l'invention présente de préférence un point d'éclair égal ou supérieur à 55°C déterminé selon la norme ASTM D 56.

La composition selon l'invention dégraisse, nettoie les huiles entières aussi bien que les huiles hydrosolubles, fonctionne par solubilisation des salissures, et est facile d'emploi. La composition selon l'invention présente l'avantage d'être recyclable facilement par distillation sous pression réduite tout en conservant les proportions d'origine.

La composition selon l'invention présente également l'avantage d'avoir une faible viscosité ainsi qu'une faible tension superficielle.

La composition peut être stabilisée. La présence d'une fonction alcool peut en présence de métaux légers, conduire à des réactions d'évolution d'hydrogène indésirables qui seraient susceptibles de mettre en péril l'installation par explosion. Parmi les inhibiteurs de telles réactions on peut utiliser des dérivés nitrés tels que le nitrométhane, le nitroéthane, le nitropropane, le nitrotoluène ; des éthers ou des acétals tels que le diméthoxyméthane, le 1,3-dioxolane, le diméthoxyméthane ; des amines telles que la triéthylamine, la dipropylamine, la diméthylamine ; des dérivés du phosphore tels que le triisodécylphosphite, le triisooctylphosphite.

Les exemples qui suivent illustrent l'invention.

### Exemple 1 (non conforme à l'invention)

Une grille en inox de 40 x 30mm est pesée après enduction avec une huile entière ou hydrosoluble fournie par CASTROL, SHELL, MOBIL ou ELF et est dégraissée à la température ambiante (21°C) par agitation manuelle dans un récipient contenant du 2-éthyl-1-hexanol, ci-après désigné par 2-EH. Le 2-EH possède une viscosité de 9,8 mPa.s, une tension superficielle de 30 mN/m et un point d'éclair de 85°C selon la norme ASTM D 56.

En 10 minutes, il ne reste plus aucune trace d'huile.

On dispose pour éliminer l'excès de solvant d'un dispositif soufflant de l'air chaud à 55°C.

Le temps de séchage est de 4 minutes 30.

### Exemple 2 (non conforme à l'invention)

On répète l'exemple 1 en immergeant la grille dans un bain de 2-EH porté à la température de 60°C afin d'accélérer la dissolution des huiles.

Dans ces conditions la grille est nettoyée en 20 secondes, le temps de séchage est de 4'30 (270 secondes).

Il n'y a aucune trace de salissure.

### Exemple 3 (non conforme à l'invention)

On opère comme dans l'exemple 1, en immergeant la grille dans un récipient contenant une composition constituée de 50% en poids de 2-EH et de 50% en poids d'une coupe pétrolière dénommée ISOPAR H.

Cette coupe présente un intervalle de distillation allant de 179°C à 192°C et un point d'éclair de 60°C selon la norme ASTM D 56.

La composition présente un point d'éclair de 57°C selon la norme ASTM D 56, une viscosité de 2,5 mPa.s et une tension superficielle de 25 mN/m.

Le nettoyage de la grille est effectuée à 40°C. Il n'y a plus de trace de salissure. Le temps de séchage à 55°C est de 105 secondes.

### Exemple 4

On opère comme dans l'exemple 3 avec une composition constituée de 20% en poids de 2-EH et 80% en poids d'une coupe pétrolière identique à celle de l'exemple 3 (ISOPAR H). Cette composition présente un point d'éclair de 55°C selon la norme ASTM D 56, une viscosité de 1,5 mPa.s et une tension superficielle de 23 mN/m. Il n'y a plus de trace de salissure et le temps de séchage à 55°C est de 80 secondes.

### Exemple 5

On opère comme dans l'exemple 3 avec une composition, constituée de 17,5% en poids de 2-EH et de 82,5% en poids d'une coupe pétrolière dénommée CEPSA D 180-200. Cette coupe présente un intervalle de distillation allant de 179° à 202° et un point d'éclair de 60°C.

Cette composition présente un point d'éclair égal à 58,5°C selon la norme ASTM D 56, une viscosité de 1,5 mPa.s et une tension superficielle de 23 mN/m.

Il n'y a plus de salissure. Le temps de séchage à 55°C est de 70 secondes.

### Exemple 6 (non conforme à l'invention)

On opère comme dans l'exemple 3 avec une composition constituée de 15% en poids de 2-EH et 85% en poids d'une coupe pétrolière dénommée CEPSA D 200-250. Cette coupe présente un intervalle de distillation allant de 200°C à 250°C.

Il n'y a plus de salissure. Le temps de séchage à 55°C est de 360 secondes.

### Exemple 7

On opère comme dans l'exemple 3 avec une composition constitue de 15% en poids de 2-EH et 85% en poids d'une coupe pétrolière identique à celle de l'exemple 3 (ISOPAR H).

Cette composition présente un point d'éclair de 56°C selon la norme ASTM D 56, une viscosité de 1,5 mPa.s et une tension superficielle de 23 mN/m.

Il n'y a plus de salissure. Le temps de séchage est de 70 secondes.

### Exemple 8 (essai de défluxage)

Dans une petite machine de laboratoire bi-cuve équipée d'un générateur d'ultrasons, on introduit 125 ml d'une composition constituée de 17,5% en poids de 2-EH et de 87,5% en poids d'lSOPAR H dans chaque cuve, puis on porte le liquide de chaque cuve à 40°C.

Cinq circuits normalisés (modèle IPC-B-25), enduits de flux de soudure à base de colophane (flux R8F de la Société ALPHAMETAL) recuits à 230°C pendant 30 secondes et refroidis, sont immergés durant trois minutes dans le liquide à 40°C sous ultrasons. Les circuits sont égouttés pendant une minute, puis rincés pendant trois minutes dans la deuxième cuve et ensuite à nouveau égouttés pendant une minute et finalement séchés à 55°C.

Le temps de séchage est de 70 secondes. La qualité du nettoyage est évaluée en déterminant le taux de résidu ionique selon la procédure normalisée IPC - TM 650 No 2.3.25 et 2.3.26, et selon la norme MIL - STD - 2000.

La valeur obtenue, 1,43 µg eq. NaCI / cm est très inférieure au seuil (2,5 µg.ég. NaCl / cm) toléré dans le domaine de l'électronique.

### Exemple 9 (essai de régénérabilité)

Dans un bouilleur d'un petit système à distiller, on introduit 100 grammes de la composition de l'exemple 7. On effectue la distillation sous une pression réduite de 110 mm de mercure.

On récupère 92% d'un mélange qui distille entre 110°C et 120°C et qui est constitué par :
- 84,8% en poids d'ISOPAR-H et
- 15,2% en poids de 2-EH.

Ces pourcentages ont été déterminés par analyse du mélange par chromatographie en phase gazeuse.

## Revendications

1. Application d'une composition au nettoyage de surfaces solides, au défluxage des circuits imprimés et au dégraissage des pièces mécaniques, contenant au moins un alcool de faible masse molaire et au moins un mélange d'alcanes, caractérisée en ce que ladite composition comprend une quantité d'alcool de faible masse molaire allant de 15 % à 20 % pour obtenir un temps de séchage à 55°C au plus égal à 80 secondes.

2. Application selon la revendication 1, caractérisée en ce que le temps de séchage à 55°C est au plus égal à 70 secondes.

3. Application selon la revendication 1, caractérisée en ce qu'elle comprend une proportion pondérale d'alcool de faible masse molaire allant de 16% à 18%.

4. Application selon l'une des revendications 1 à 3, caractérisée en ce que l'alcool de faible masse molaire est le 2-éthyl-1-hexanol.

5. Application selon la revendication 1, caractérisée en ce que le mélange d'alcanes est une coupe pétrolière ayant un nombre de carbone allant de 9 à 12.

6. Application selon la revendication 5, caractérisée en ce que la coupe pétrolière présente un intervalle de distillation allant de 170°C à 210°C.

7. Application selon la revendication 6, caractérisée en ce que la coupe pétrolière présente un intervalle de distillation allant de 175°C à 200°C.
